# EUROPEAN PATENT APPLICATION

(11) **EP 0 709 930 A2**
(43) Date of publication of application: **01.05.1996**
(21) Application number: 95307133.9
(22) Date of filing: 09.10.1995
(51) Int. Cl.: H01R 23/00

(54) **Capacitive trace coupling for reduction of crosstalk**

(30) Priority: 28.10.1994 US 331318
(71) Applicant: THE WHITAKER CORPORATION, Wilmington, Delaware 19808 (US)
(72) Inventor: Hoffman, Bette Lynn, Brown Carolina 27214 (US); Ferry, Julian J., Kernersville, North Carolina 27284 (US)
(74) Representative: Warren, Keith Stanley

(57) **Abstract**

A planar electronic device (10), such as a printed circuit board offers capacitive trace coupling for reduction of crosstalk within the device, a pair of connectors (12,14) being electrically interconnected by the planar electronic device (10). The device (10) comprises a dielectric board (18) having first and second major surfaces (20,22) defined by parallel planes with plural pairs of electrically conductive traces (16) along the respective major surfaces (20,22). Alternate pairs (16-1,16-1a,16-3, 16-3a) are arranged on first major surface (20), and the remaining pairs (16-2,16-2a,16-4,16-4a) are arranged on the second major surface (22). Additionally, a conductive trace (16-2a,16-4,16-4a) of a given pair on the second surface (22) is vertically aligned with a conductive trace (16-1a,16-3,16-3a) of an adjacent pair on the first surface (20) over at least a portion of the length of said conductive trace. By this arrangement of conductive traces (16), a reduction in crosstalk is achieved.

## Description

This invention relates to an improved planar electronic device, such as a printed circuit board, that utilizes a unique circuit trace pattern on the respective major surfaces of the device to achieve a reduction in crosstalk resulting in the improved performance within the device, and in the electrical connectors joined thereby. Crosstalk problems are particularly severe in high frequency transmission applications. Such crosstalk problems can arise in the transmission cable, connecting hardware, such as electrical connectors, or in the circuit assembly which typically electrically interconnects at least a pair of electrical connectors in series.

In electrical connectors used in twisted pair Local Area Networking (LAN) applications, crosstalk is caused predominantly by imbalances in the capacitive coupling between the terminals or conductors. The most common approach to reducing crosstalk is based on changing the capacitances between certain conductors. This may be accomplished in one of two ways: by either re-routing conductor paths in unusual ways, such as taught in U.S. Patent Nos. 5,186,647 and 5,362,257, the latter assigned to the assignee hereof, or by adding small values of capacitance between certain conductors. The last approach is disclosed and claimed in U.S. Patent No. 5,341,419, by one of the inventors, and assigned to the assignee hereof. In any case, both methods are often used simultaneously.

In the re-routing method, conductors that require more coupling can be moved closer together, and those that need less coupling can be separated further. This can be accomplished by "twisting" the terminals of a connector, by routing traces on a printed circuit board closer together or over top of one another, or even by increasing and/or decreasing the size of certain conductors. A recent approach to the re-routing method is taught in U.S. Patent No. 5,299,956 where the circuit traces or paths are relocated on a printed circuit board.

Further to the above prior art methods, additional capacitance can be added by simply adding discrete capacitors, or by branching off from the main conductor path with an additional conductor. This additional conductor can then be run over top or adjacent to another conductor, as in the re-routing method. In fact, it is sometimes difficult to determine exactly where on method ends and the other begins. U.S. Patent No. 5,326,284 teaches a printed circuit board (PCB) assembly and connector means wherein at least two pairs of conductor paths are arranged along the PCB. The assembly includes a parasitic reactive coupling in the connector means between a first conductor of one pair and first conductor of the second pair, and the circuit member or PCB includes a compensating reactive means between the first conductor of one pair and second conductor of the second pair. Briefly, the capacitors, as noted above, are essentially plates branching off from respective conductor paths.

The present invention offers a different approach to achieve a reduction in crosstalk by the unique arrangement of the circuit traces or paths of adjacent pairs of conductors on different major surfaces of a planar electronic device, such as a printed circuit board. The manner by which this is achieved will be apparent in the description which follows, particularly when read in conjunction with the accompanying drawings.

The present invention is directed to a planar electronic device, such as a printed circuit board (PCB), offering capacitive trace coupling for reduction of crosstalk between a pair of connectors electrically interconnected by the planar electronic device. The device comprises a dielectric board having first and second major surfaces defined by spaced apart parallel planes, having plural pairs of electrically conductive circuit traces or paths along the respective major surfaces. The improved feature hereof is the provision of alternate pairs arranged on a first major surface, with the remaining pairs arranged on the second major surface. Additionally, a conductive trace or path of a given pair on the second surface is vertically aligned with a conductive trace or path of an adjacent pair on he first surface over at least a portion of the length of said conductive trace. By this arrangement of the conductive traces or path, the device satisfies the definition of a capacitor without the use or introduction of separate capacitive elements.

Embodiments of the invention will now be described by way of example with reference to the accompanying drawings in which:
FIGURE 1 is an exploded perspective view showing a pair of exemplary electrical connectors, which when engaged with a planar electronic device, such as a printed circuit board, are electrically interconnected thereby through a circuit pattern of electrical traces, offering an enhanced performance by the said circuit pattern along the printed circuit board that reduces crosstalk between adjacent pairs of said electrical traces;
FIGURES 2 and 3 are perspective views of the top and bottom surfaces, respectively, illustrating a preferred embodiment of a circuit pattern embodiment of a circuit pattern for the printed circuit of this invention;
FIGURE 4 is a plan view of a preferred printed board according to the invention hereof;
FIGURE 5 is a sectional view taken along line 5-5 of Figure 4 illustrating the aligned relationship of certain traces on the top and bottom surfaces;
FIGURE 6 is an exploded perspective view of the printed circuit board of Figure 1, where the circuit traces along the top and bottom surfaces have been spaced from the board to further illustrate the manner by which the circuit traces are arranged to effect a reduction in crosstalk, whereby to improve the performance of the electrical connectors engaged therewith;
FIGURE 7 is a top view of a second embodiment of this invention, showing the traces on the top surface in solid lines with the traces on the bottom surface in dotted lines; and
FIGURE 8 is an exploded perspective view of the second embodiment of Figure 7, where the traces along the top and bottom surfaces have been spaced from the board in the manner of Figure 6.

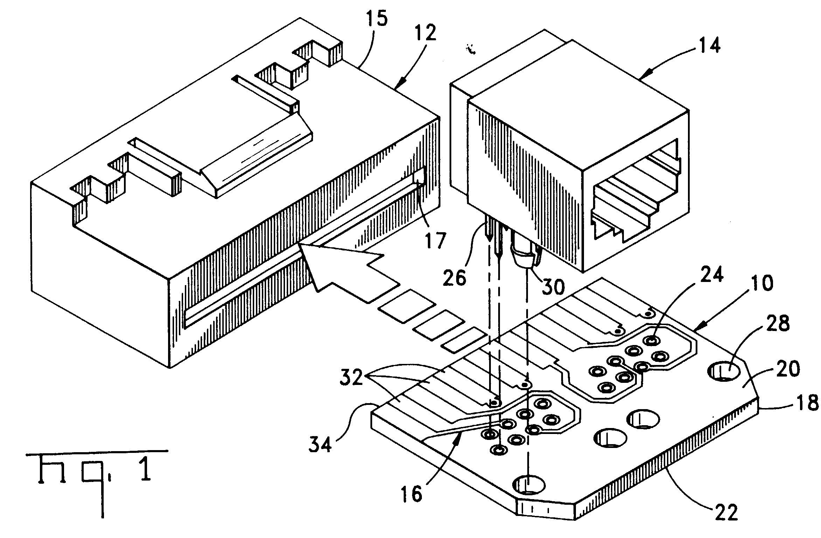

The preferred embodiment of the invention relates to an improved planar electronic device, such as a printed circuit board (PCB), that offers reduced crosstalk within the device, and in a pair of electrical connectors engaged therewith. Figure 1 is an exemplary embodiment of the application of the device 10 of this invention, and a pair of electrical connectors 12, 14, to be electrically engaged therewith. While this application shows the use of a card edge type connector 12, and a surface mounted modular jack 14, it will be understood that different and plural connectors may be used without departing from the spirit and scope of this invention. However, for convenience, the further description will be directed to the use of at least one card edge type connector, as known in the art, with particular emphasis on the conductive trace or path pattern 16 of the planar electronic device 10. While such card edge connectors are well known, they briefly consist of a generally rectangular housing 15 having plural contacts or terminals therein, where the housing includes a card edge receiving slot 17 into which a PCB or card may be inserted to electrically engage said contacts or terminals.

As illustrated in the several Figures, the planar electronic device 10 comprises a dielectric, planar body 18 having an upper or top major surface 20 and a lower or bottom major surface 22 parallel to each other. The device 10, for surface mounting applications, may include plural plated through or via holes 24 for receiving complementary signal pins 26 of an electrical connector 14 to be joined to the device. Additionally, mounting holes 28 may be included for receiving connector legs 30, a system for surface mounting as known in the art.

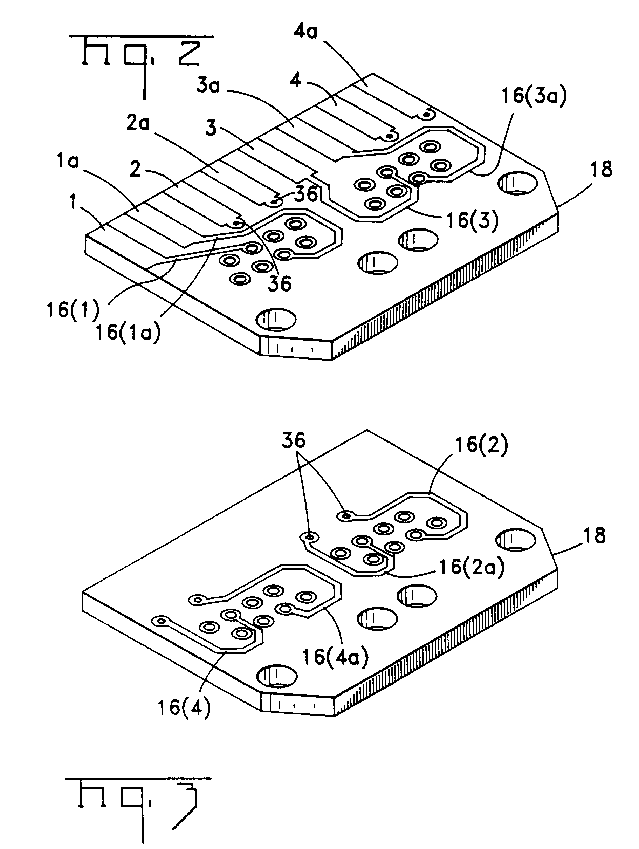

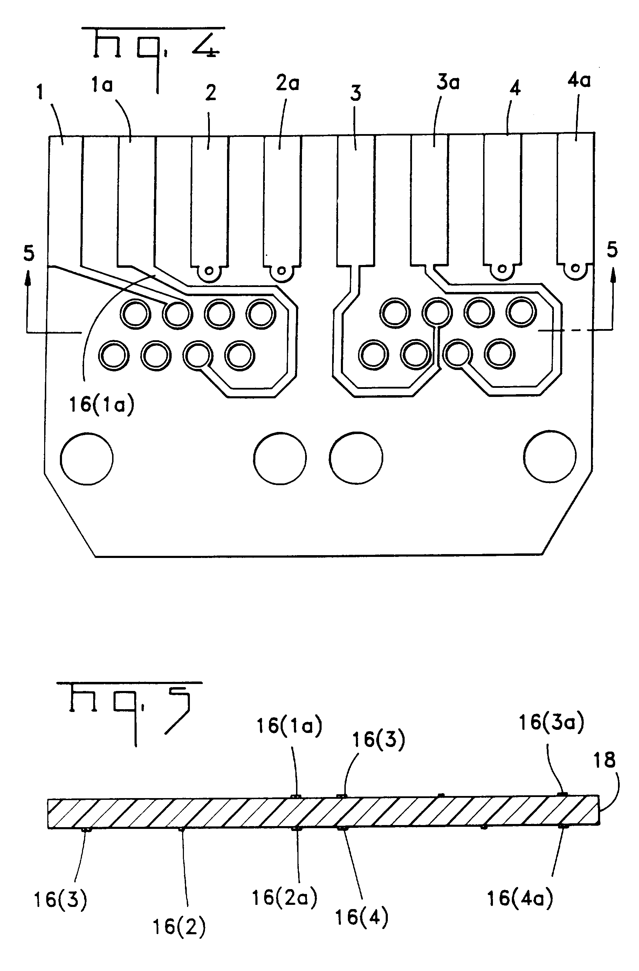

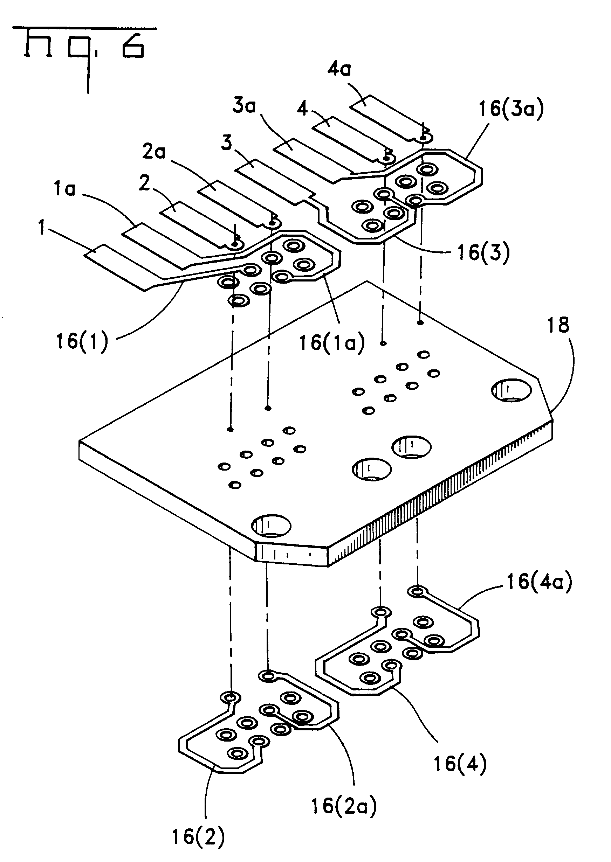

For the preferred device 10 of the Figures 1-6, plural conductive pads 32 are disposed a distance from the plated through holes 24 along a device edge 34, where such edge may be inserted into a complementary connector 12 for electrical engagement therewith. Between respective pads 32 and plated through holes 24 a plurality of conductive traces or paths 16 are provided.

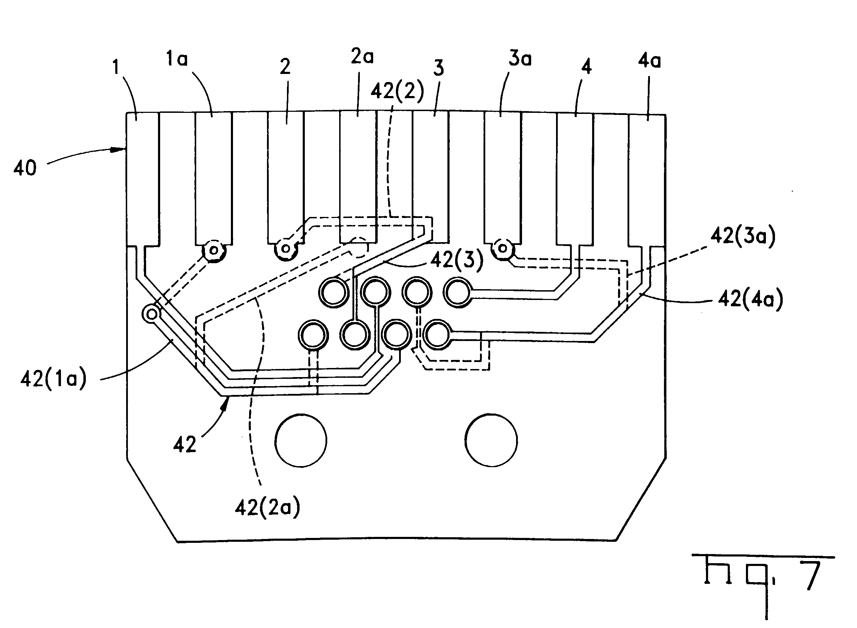

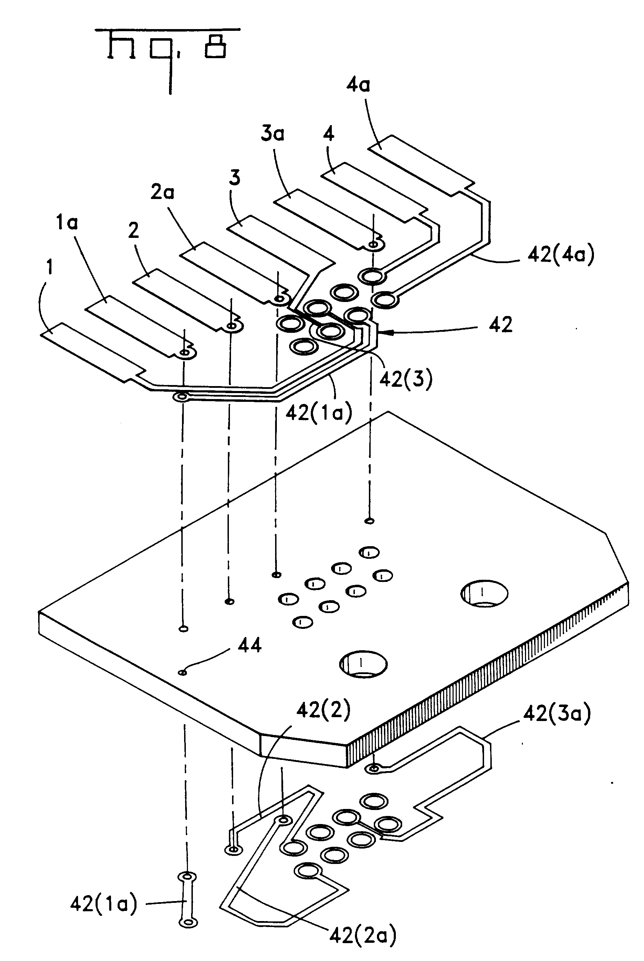

For convenience in understanding the invention, the individual conductive pads 32 have been identified from one side edge to the other as 1 - 1a - 2 - 2a - 3 - 3a and 4 -4a, where a typical arrangement consists of four pairs. In this embodiment the traces 16 (1 - 1a) from conductive pads 1 - 1a are disposed along the upper surface 20 while the traces 16 (2-2a) from conductive pads 2 - 2a, by means of plated via holes 36, are disposed along the lower surface 22 (see Figure 5). In addition, at least one trace 16 (1a) along the upper surface 20, for example, is vertically aligned over a portion of its path to a trace 16 (2a) disposed along the lower surface 22 (see Figure 3). In a similar fashion, trace 16 (3) is vertically aligned with trace 16 (4) and trace 16 (3a) is vertically aligned with trace 16 (4a). Thus, in each case, though a different circuit trace or path pattern is illustrated, a conductive trace from a given pair of traces is vertically aligned, i.e. separated by the thickness of the dielectric body 18, with at least one trace from an adjacent pair of traces. In the single, exploded perspective of Figure 6, this alignment may be clearly seen.

This manner of reducing crosstalk is distinctly different from the prior art where the addition of capacitive elements or discrete traces are required, or by the mixing or intermingling of pairs of conductive traces. It should be noted that the preferred embodiment of the Figures show the traces of a given pair of traces lie exclusively on only one surface of the dielectric body 18. However, one of such traces may initially lead from the opposite side then continue by means of an intermediate via hole to the opposite side with the other trace of such given pair. Note the embodiment of Figures 7 and 8. Considering again the designation of the card edge traces 40 and 1 - 1a - 2 - 2a - 3 - 3a and 4 - 4a, left to right, it will be noted that the conductor 42 (1a) leading from trace 40 (1a) initially is along the lower surface of the planar member then through via hole 44 to the upper surface. Conductor 42 (2a), from the adjacent pair of conductors, is solely on the lower surface with a major portion of its length vertically underlying and in non ohmic contact with a portion of conductor 42 (1a). In a similar fashion, it will be seen that conductor 42 (2) underlies a portion of the path of conductor 42 (3), while conductor 42 (3a) underlies a portion of the path of conductor 42 (4a). Again, the critical feature which allows the device to provide for reduced crosstalk, through capacitive coupling, is the provision of the vertical alignment of traces from adjacent pairs of circuit traces.

## Claims

1. A planar electronic device (10) offering capacitive trace coupling for reduction of crosstalk within the device, and a pair of connectors (12,14) electrically interconnected by said planar electronic device (10), said device (10) comprising a dielectric board (18) having first and second major surfaces (20,22) defined by parallel planes, plural pairs of electrically conductive traces (16) along the respective said major surfaces, characterized in that at least a significant portion of alternate said pairs (16-1,16-1a,16-3,16-3a) are arranged on said first major surface (20), and the remaining said pairs (16-2,16-2a,16-4, 16-4a) are arranged at least in part on said second major surface (22), whereby a conductive trace (16-2a,16-4,16-4a) of a given pair on said second surface (22) is vertically aligned with a conductive trace (16-1a,16-3,16-3a) of an adjacent said pair on said first surface (20) over at least a portion of the length of said conductive trace.

2. The planar electronic device according to claim 1 wherein said conductive traces (16) extend between sets of connector contacts (24,32).

3. The planar electronic device according to claim 1 wherein one set of connector contacts are pads (32) along an edge (34) of said device (10) for electrical reception in a card edge electrical connector (12).

4. The planar electronic device according to claim 1 wherein one set of connector contacts are metallic plated through holes (24) for receipt of a surface mounted electrical connector (14).

5. The planar electronic device according to claim 4 wherein there are plural sets of plated through holes (24) for receiving a like plurality of surface mounted electrical connectors (14).

6. The planar electronic device according to claim 1 wherein said conductors (16-1,16-1a,42-1a,42-2a) of at least one given pair are arranged parallel to one another over at least a portion of the length of the conductive traces.

7. The planar electronic device according to claim 6 wherein at least one conductive trace (42-1a,42-2a, 42-3a) may traverse a portion of both of said major surfaces (20,22), interconnected by a via hole (24), provided it is parallel to its companion conductive trace over a portion of one said major surfaces.
